# FASCICULE DE BREVET EUROPEEN

(11) **EP 2 507 416 B1**
(45) Date de publication et mention de la délivrance du brevet: **18.06.2014**
(21) Numéro de dépôt: 10784797.2
(22) Date de dépôt: 30.11.2010
(51) Int. Cl.: C30B 11/00, C30B 29/06, C30B 28/06, C30B 35/00

(54) **DISPOSITIF DE GUIDAGE D'ONDES ULTRASONORES ADAPTE A UNE UTILISATION DANS UN FOUR DE SOLIDIFICATION DIRIGÉE DU SILICIUM**
ULTRASCHALLWELLENLEITER ZUR VERWENDUNG IN EINEM OFEN FÜR GERICHTETE ERSTARRUNG FÜR SILIZIUM
ULTRASONIC WAVEGUIDE DEVICE SUITABLE FOR USE IN A DIRECTIONAL SOLIDIFICATION FURNACE FOR SILICON

(30) Priorité: 30.11.2009 FR 0958524
(43) Date de publication de la demande: 10.10.2012
(73) Titulaire: Commissariat à l'Énergie Atomique et aux Énergies Alternatives, 75015 Paris (FR); Centre National de la Recherche Scientifique, 75016 Paris (FR)
(72) Inventeur: GARANDET, Jean-Paul, F-73370 Le Bourget du Lac (FR); BOTTON, Valery, F-38510 Saint-Sorlin de Morestel (FR); CAMEL, Denis, F-73000 Chambéry (FR); DREVET, Béatrice, F-38000 Grenoble (FR)
(74) Mandataire: Ilgart, Jean-Christophe
(86) Numéro de dépôt international: PCT/EP2010/068532
(87) Numéro de publication internationale: WO 2011/064390

(56) Documents cités:
- DE-A1- 10 234 250
- JP-A- 59 083 995
- JP-A- 2007 110 371
- US-B1- 6 506 250
- DOLD P ET AL: "In situ observation of growth interfaces by ultrasound", JOURNAL OF CRYSTAL GROWTH, vol. 256, no. 3-4, septembre 2003 (2003-09), pages 352-360, XP002586528, ELSEVIER NL DOI: DOI:10.1016/S0022-0248(03)01405-2 cité dans la demande
- YOSHIMOTO N ET AL: "Sound velocity of molten silicon", PHYSICA B: CONDENSED MATTER, vol. 219-220, no. 1-4, 23 juillet 1995 (1995-07-23), pages 623-625, XP002586529, ELSEVIER SCIENCE B.V. DOI: DOI:10.1016/0921-4526(95)00832-2 cité dans la demande

## Description

### DOMAINE TECHNIQUE

L'invention a trait à un dispositif de guidage d'ondes ultrasonores qui est apte à être utilisé dans un four de cristallisation du silicium selon un procédé de solidification dirigée.

Un tel dispositif de guidage peut alors être utilisé dans un système de contrôle de l'état d'avancement de la cristallisation d'un bain de silicium fondu ou dans un système de brassage d'un bain de silicium fondu.

### ÉTAT DE LA TECHNIQUE ANTÉRIEURE

Le silicium est le substrat de base le plus utilisé pour la production de composants électroniques. En particulier, le silicium est essentiel pour la production de cellules photovoltaïques.

Le silicium qui est utilisé pour des applications en microélectronique ou dans la fabrication des cellules photovoltaïques est élaboré dans des filières qui mettent en jeu la solidification de lingots à partir d'un bain liquide de silicium.

Les procédés de solidification dirigée du silicium utilisés pour obtenir le silicium doivent être contrôlés de manière minutieuse afin que les produits obtenus soient reproductibles. Or, pour certaines applications et notamment pour les applications des cellules photovoltaïques où la croissance se fait sous la forme de lingots multi-cristallins de plusieurs centaines de kilogrammes, un contrôle fin du processus de solidification nécessiterait la mise en place de moyens de diagnostics in situ.

Par ailleurs, la tendance à l'augmentation de la taille des lingots cristallisés et l'utilisation, comme source de silicium, de matériaux silicium de moindre pureté nécessite de brasser la phase liquide à l'avant du front de solidification.

Enfin, les contraintes en termes de niveau d'impuretés résiduelles dans les matériaux en silicium cristallisé pour les applications en microélectronique, et en particulier pour la réalisation de cellules photovoltaïques, sont très sévères, ce qui limite fortement la gamme des matériaux utilisables dans l'enceinte de cristallisation et exclut en particulier l'utilisation de matériaux métalliques.

Il est connu que le brassage et la vérification de l'état d'avancement de la cristallisation dans un procédé de solidification dirigée peuvent être obtenus en utilisant des ultrasons. En effet, les techniques ultrasonores ont été étudiées en liaison avec les procédés de solidification à la fois comme moyens de diagnostics et comme moyens d'agir sur le régime de convection.

En ce qui concerne les moyens de diagnostics, l'état d'avancement de la cristallisation se fait généralement en contrôlant la position et la vitesse de l'interface solide-liquide. L'interface solide-liquide peut être déduite de la mesure du temps de vol d'un écho ultrasonore, émis par un transducteur collé sur la partie solide du matériau cristallisé, qui se réfléchit partiellement sur l'interface solide-liquide du fait d'une différence d'impédance mécanique entre les deux phases (voir le document **[1]** référencé à la fin de la description).

La précision de cette technique est satisfaisante (de l'ordre de la dizaine de micromètres), mais elle suppose de pouvoir accéder à la phase solide en partie froide du matériau solidifié, ce qui complique la conception du dispositif de mesure, et qui exclut les procédés utilisant une fusion complète du matériau. D'autre part, la nécessité de disposer d'une colle permettant le couplage entre le transducteur et la phase solide limite cette technique à des matériaux ayant une température de fusion relativement basse.

Concernant la mise en oeuvre de techniques basées sur les ultrasons à haute température comme moyens de convection, il est intéressant de citer l'étude des vitesses d'écoulement par vélocimétrie Doppler dans des alliages métalliques liquides Pb-Bi et Cu-Sn (voir le document **[2]**). Pour tenir compte des limitations en température de Curie des transducteurs utilisés, et déporter la source piézo-électrique en dehors de l'enceinte de fusion, les auteurs de ce document développent un système de guide d'onde basé sur un matériau acier inoxydable. Les températures investiguées ne dépassent pas les 620°C, gamme dans laquelle l'acier convient très bien. Cependant, l'acier inoxydable n'est pas fait pour travailler aux températures utilisées pour la solidification du silicium et il induirait de toute façon des pollutions chimiques inacceptables.

Dans cette même gamme de température, on peut également citer les travaux de Kozhemyakin et al. sur la croissance cristalline d'alliages Ga-In-Sb (voir le document **[3]**). Kozhemyakin et al. agissent sur la ségrégation chimique dans les alliages en induisant des mouvements de convection dans le fluide au moyen d'une vibration contrôlée du creuset. Un barreau de verre de silice, fixé dans le fond du creuset, est utilisé comme guide d'ondes ultrasonores. Si la silice est acceptable en tant que matériau dans un -four de solidification du silicium, la stabilité de sa forme vitreuse limite ses applications en tant que guide d'onde à des températures inférieures à 1200°C.

L'utilisation de techniques ultrasonores à des températures supérieures à 1400°C est très rare dans la littérature. Une étude particulièrement intéressante pour notre propos est celle de Yoshimoto et al. (voir le document **[4]**), car ces auteurs se sont intéressés à la mesure de la vitesse du son dans le silicium liquide. Pour transmettre l'énergie acoustique dans l'enceinte haute température, un guide d'onde en alumine monocristalline est utilisé. L'alumine présente l'avantage d'avoir une bonne tenue mécanique jusqu'à 1700°C. De plus, sa réactivité limitée avec le silicium liquide permet la réalisation d'expériences de courte durée sur des petits échantillons. Cependant, vu la longue durée des expériences de solidification (de l'ordre de la dizaine d'heures), l'alumine induirait dans le silicium des pollutions en aluminium inacceptables pour les applications visées. Un guide d'onde en quartz est aussi utilisé dans la littérature (voir le document [5])*.*

En conclusion, les matériaux des guides d'ondes proposés dans l'état de l'art ne conviennent pas à une utilisation pour la transmission et la réception de l'énergie acoustique d'une onde ultrasonore dans l'environnement haute température d'un four adapté à la solidification du silicium.

Les inventeurs se sont donc fixé comme but de concevoir un guide d'ondes ultrasonores compatible avec une utilisation dans un four de solidification dirigée du silicium.

### EXPOSÉ DE L'INVENTION

Ce but est atteint grâce à un dispositif de guidage d'ondes ultrasonores apte à être utilisé dans une enceinte thermiquement isolante d'un four de cristallisation du silicium et destiné à être inséré partiellement dans l'enceinte dudit four par un orifice ménagé dans la paroi de l'enceinte, caractérisé en ce qu'il comprend :
- un guide d'onde en silice cristalline, comprenant une face d'entrée d'une onde ultrasonore, une face de sortie d'une onde ultrasonore et une surface latérale reliant la face d'entrée et la face de sortie,
- une structure en graphite ou en carbure de silicium, qui entoure au moins partiellement la surface latérale du guide d'onde,
- une couche intermédiaire pulvérulente en nitrure de silicium ou en carbure de silicium, qui recouvre au moins les portions de la surface latérale du guide d'onde qui sont entourées par la structure.

Le guide d'onde est un corps plein en silice cristalline, de préférence rectiligne, comprenant une surface latérale reliant deux extrémités (face d'entrée et face de sortie d'une onde ultrasonore), et dont la section droite peut être indifféremment circulaire, oblongue ou polygonale (par exemple triangulaire, rectangulaire, carrée, hexagonale...), étant entendu que les sections carrée et circulaire sont préférées pour des raisons de simplicité.

La structure, quant à elle, va venir épouser les contours de la surface latérale du guide d'onde. Il peut s'agir par exemple d'une gaine ou d'un manchon. C'est cette structure qui va permettre au guide d'onde de conserver ses propriétés mécaniques, et en particulier sa forme, dans l'environnement haute température au sein de l'enceinte.

On entend par « couche pulvérulente » une couche comprenant des particules de tailles comprises entre 0,1 et 5 micromètres et des espaces entres les particules dont la taille est voisine de celles des particules. Cette couche pulvérulente peut par exemple être obtenue par frittage partiel de particules sur le guide d'onde.

Dans ce qui précède et ce qui suit, le terme « taille », appliqué à des particules ou à des espaces, désigne la dimension caractéristique de ces particules ou de ces espaces. La détermination de la taille des particules et des espaces peut par exemple être obtenue par MEB (Microscopie Electronique à Balayage).

Avantageusement, la structure recouvre de 40 à 100% de la surface latérale du guide d'onde, préférentiellement de 60 à 80%. D'autre part, la structure peut être pleine ou ajourée.

De préférence, la structure est présente en priorité sur la portion de la surface latérale du guide d'onde qui est située à l'intérieur de l'enceinte.

L'invention concerne aussi un système de contrôle de l'état d'avancement de la cristallisation d'un bain de silicium fondu réalisée dans une enceinte thermiquement isolante d'un four de cristallisation, comprenant une source d'ultrasons et un détecteur d'ultrasons, caractérisé en ce que :
- la source d'ultrasons comprend n ensemble(s), n étant un nombre entier supérieur ou égal à 1, chaque ensemble de la source comprenant un transducteur, apte à émettre une onde ultrasonore, relié à un dispositif de guidage d'onde selon l'invention, apte à guider l'onde ultrasonore, produite par ledit transducteur, vers l'interface vapeur-liquide du bain de silicium liquide ;
- le détecteur d'ultrasons comprend au moins 2n ensembles, chaque ensemble du détecteur comprenant un dispositif de guidage d'onde selon l'invention relié à un transducteur apte à détecter une onde ultrasonore, ledit dispositif de guidage d'onde étant apte à guider une onde ultrasonore vers ledit transducteur ;

les n ensembles de la source et les au moins 2n ensembles du détecteur étant placés au dessus de l'interface vapeur-liquide en des positions distinctes telles que l'onde ultrasonore produite par l'un des transducteurs de la source soit incidente sur l'interface vapeur-liquide selon un angle aigu par rapport à la normale à ladite interface et que ladite onde ultrasonore, réfléchie par l'interface vapeur-liquide selon ce même angle aigu, soit détectée par l'un des transducteurs du détecteur,

les transducteurs de la source et du détecteur étant situés à l'extérieur de l'enceinte et les dispositifs de guidage d'onde de la source et du détecteur traversant la paroi de ladite enceinte.

De préférence, la ou les n dispositifs de guidage d'onde de la source sont disposées selon une ligne essentiellement parallèle à l'interface vapeur-liquide du bain liquide ou bien selon une matrice dont la ou les lignes sont essentiellement parallèles à l'interface vapeur-liquide.

De même, les au moins 2n dispositifs de guidage d'onde du détecteur sont de préférence disposés selon une ligne ou selon une matrice dont la ou les lignes sont essentiellement parallèles à l'interface vapeur-liquide.

Avantageusement, les dispositifs de guidage d'onde du détecteur sont disposés selon une matrice (ixj), avec i lignes et j colonnes, i et j étant des nombres entiers supérieurs ou égaux à 1 et i×j ≥ 2.

L'invention concerne également un système de brassage d'un bain de silicium fondu dans une enceinte thermiquement isolante d'un four de cristallisation, comprenant au moins un moyen de brassage destiné à être mis en contact avec la surface du bain de silicium fondu, caractérisé en ce que ledit moyen de brassage comprend un dispositif de guidage d'ondes ultrasonores selon l'invention.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des figures annexées parmi lesquelles :
- la figure 1 représente un guide d'onde utilisé dans le dispositif de guidage d'onde selon l'invention ;
- la figure 2 représente, selon une vue en coupe longitudinale, le dispositif de guidage-d'ondes ultrasonores selon un premier exemple de réalisation de l'invention ;
- la figure 3 représente, selon une vue en coupe longitudinale, le dispositif de guidage d'ondes ultrasonores selon un second exemple de réalisation de l'invention ;
- la figure 4 représente une vue en coupe verticale d'une enceinte thermiquement isolante d'un four de cristallisation comprenant un système de contrôle de l'état d'avancement de la cristallisation utilisant un dispositif de guidage d'onde ultrasonore selon l'invention ;
- la figure 5 représente un détail en gros plan de la figure 4 ;
- la figure 6 représente une vue en coupe verticale d'une enceinte thermiquement isolante d'un four de cristallisation comprenant un système de brassage utilisant un dispositif de guidage d'onde ultrasonore selon l'invention ;
- la figure 7 représente un détail en gros plan de la figure 6.

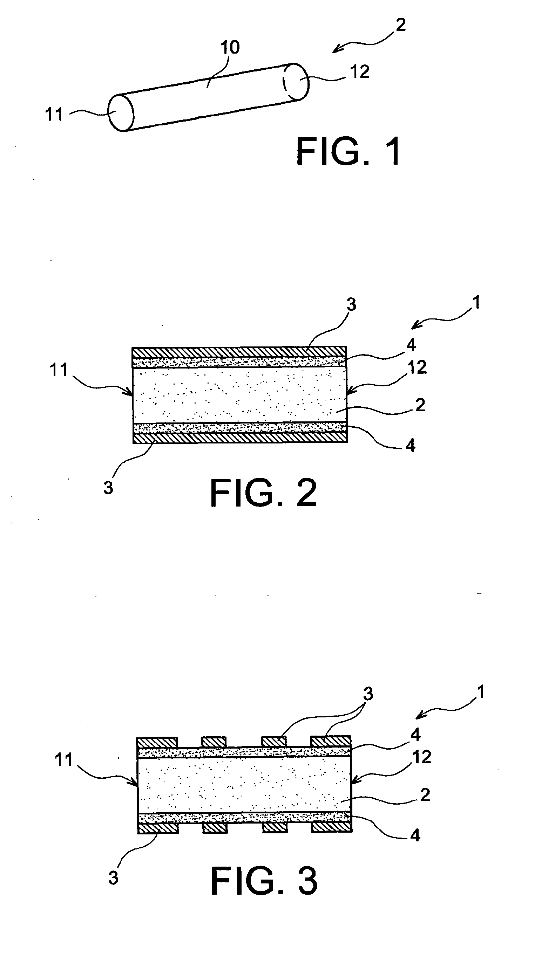

Il est à noter que les éléments constitutifs des figures, et notamment la couche intermédiaire et la structure, ne sont pas représentés à l'échelle. Dans la figure 1, la couche intermédiaire et la couche ne sont pas représentées.

### EXPOSÉ DÉTAILLÉ DE MODES DE RÉALISATION PARTICULIERS

Pour transmettre et réceptionner une onde ultrasonore au sein d'une enceinte thermiquement isolante d'un four adapté à la solidification du silicium, on utilise selon l'invention un dispositif de guidage d'onde 1 comprenant un guide d'onde 2 en silice cristalline, par exemple une âme ou un barreau.

Ce guide d'onde 2, comme représenté dans la figure 1, est un corps plein qui comporte une face d'entrée 11 d'une onde ultrasonore, une face de sortie 12 d'une onde ultrasonore et une surface latérale 10 reliant les deux faces (figure 1).

La surface latérale 10 du guide d'onde est entourée par une structure 3 et une couche intermédiaire pulvérulente 4 est disposée sur le guide d'onde au moins sur les parties de la surface latérale entourée par la structure (figures 2 et 3).

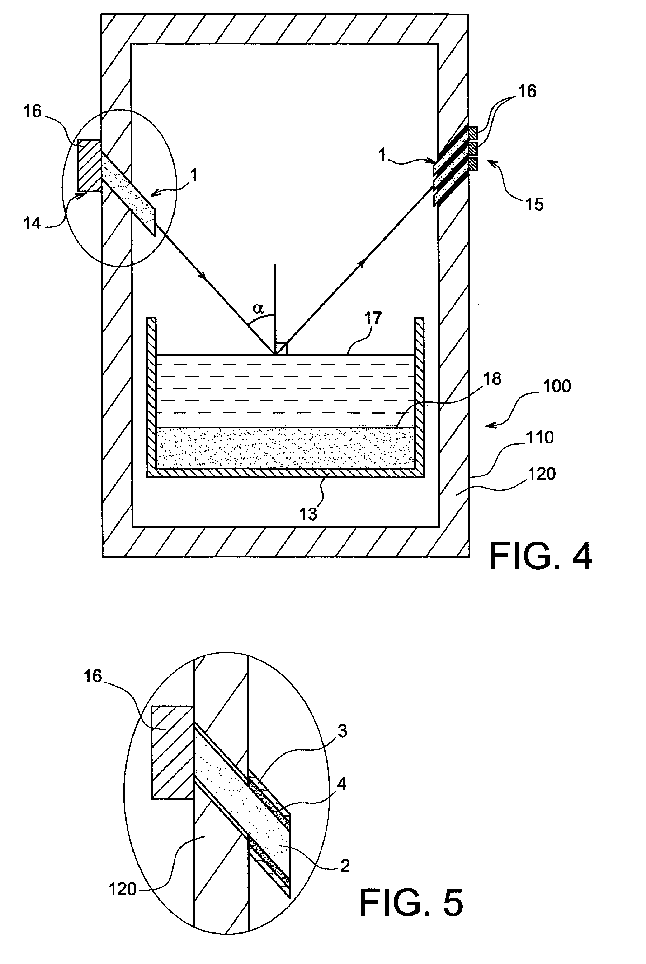

La structure peut être pleine (figure 2) ou ajourée (figure 3) et elle peut recouvrir tout (figure 2) ou partie de la surface latérale du guide d'onde (figure 3 et figure 5).

Dans la figure 5, qui sera décrite plus loin, seule la portion de la surface latérale du guide d'onde destinée à être à l'intérieur de l'enceinte isolante est recouverte par la structure 3 en graphite ou en carbure de silicium.

La couche intermédiaire pulvérulente peut quant à elle recouvrir tout (figure 2 et figure 3) ou partie (figure 5) de la surface latérale du guide d'onde, cette couche intermédiaire étant toutefois toujours présente entre le guide d'onde et la structure afin d'éviter tout contact entre le guide d'onde et ladite structure : la couche intermédiaire est présente à toutes les interfaces entre la silice cristalline et la structure en graphite ou en carbure de silicium.

Le dispositif de guidage d'ondes ultrasonores ainsi conçu permet alors d'introduire les ultrasons de façon fiable et reproductible dans l'enceinte de cristallisation.

Dans l'invention, la silice cristalline que l'on utilise est du quartz. Les propriétés mécaniques du quartz au dessus de 1300°C sont très mauvaises. Il n'était donc pas du tout évident a priori de l'utiliser pour l'application visée.

C'est la structure 3 en graphite ou en carbure de silicium, entourant le guide d'onde de silice cristalline 2, qui assure la tenue mécanique du dispositif de guidage d'onde 1. Le graphite et le carbure de silicium conservent de très bonnes propriétés mécaniques à haute température et ils sont relativement peu gênants pour une utilisation dans un four de solidification du silicium, car ils sont déjà présents dans les fours de croissance du silicium et ne provoquent donc pas de contamination supplémentaire.

En outre, la présence de la couche intermédiaire pulvérulente entre le guide d'onde et la structure permet d'éviter ou de réduire les pertes de transmission de l'énergie liées à un couplage acoustique entre le graphite ou le carbure de silicium et la silice cristalline, dont les impédances acoustiques sont proches.

D'autre part, au niveau mécanique, la présence de la couche intermédiaire permet d'éviter ou de réduire les contraintes dues à la différence entre les coefficients de dilatation du graphite ou du carbure de silicium et de la silice cristalline.

Enfin, au niveau chimique, la présence de la couche intermédiaire permet d'éviter que se produise une réduction de la silice à l'interface silice-graphite ou silice-carbure de silicium avec un dégagement de monoxyde de carbone.

La couche intermédiaire entre la silice cristalline du guide d'onde et le graphite ou le carbure de silicium peut par exemple être déposée par pistoletage ou par trempage, suivi d'un frittage partiel.

La couche intermédiaire a une épaisseur comprise entre 50 et 200 micromètres ; les grains de nitrure de silicium ou de carbure de silicium formant cette couche ont une taille comprise entre 0,1 et 5 micromètres et les espaces entre les grains ont une taille voisine de celle des grains.

Le nitrure de silicium est classiquement utilisé comme revêtement anti adhérent sur les creusets destinés à contenir du silicium ; son utilisation dans un environnement de four de solidification est donc tout à fait acceptable.

D'autre part, étant donné la présence de quantités importantes de graphite dans les fours de solidification, le carbure de silicium est lui aussi autorisé.

De par sa nature pulvérulente, la couche intermédiaire possède une faible impédance acoustique. Elle permet ainsi le découplage entre la silice cristalline et le graphite ou le carbure de silicium et, donc, la bonne transmission de l'énergie acoustique. Toujours grâce à sa nature pulvérulente, cette couche intermédiaire permet également d'accommoder les contraintes de dilatation différentielle. Enfin, cette couche permet d'éviter un contact entre la silice et le graphite, ce qui a pour effet de réduire l'oxydation du graphite.

Selon un exemple de réalisation pour une application de détection, on utilise un barreau de silice cristalline (quartz), par exemple un barreau de 50 millimètres de long et 10×10 mm² de section droite.

Selon un exemple de réalisation pour une application dé brassage, on utilise par exemple des barreaux de 30 cm de long et de 2x2 cm² de section droite.

Sur les barreaux des deux exemples ci-dessus, on dépose par trempage une couche de nitrure de silicium d'épaisseur 100 µm sur l'ensemble de la surface du barreau de silice. Puis, on adapte une structure en graphite ayant une épaisseur comprise généralement entre 2 et 8 mm, par exemple de 5 mm, autour de chacun des barreaux. La forme de la structure est adaptée en fonction de la forme du guide d'onde. Par exemple, dans le cas d'un guide d'onde de forme tubulaire (barreau), la structure sera un manchon de forme tubulaire pouvant s'adapter aux contours du guide d'onde.

Le dispositif de guidage d'onde selon l'invention peut être utilisé dans une enceinte thermiquement isolante d'un four de cristallisation pour obtenir la solidification d'un bain de silicium. Il peut être utilisé pour effectuer le brassage du bain de silicium ou bien encore pour vérifier l'état d'avancement de la cristallisation du bain de silicium.

Selon un premier exemple de réalisation illustré dans la figure 4, le dispositif de guidage d'onde ultrasonore 1 selon l'invention est utilisé dans un système de contrôle de l'état d'avancement de la cristallisation d'un bain de silicium fondu.

On considère un four de solidification dirigée 100 de type Heat Exchanger Method à chauffage résistif, adapté à la croissance du silicium pour des applications photovoltaïques et travaillant sous balayage d'argon.

Le système de contrôle comprend un émetteur d'ultrasons 14 et un récepteur d'ultrasons 15. L'objectif est de mesurer la position et éventuellement la vitesse de l'interface liquide-vapeur 17 du bain de silicium en détectant la position d'un spot ultrasonore se réfléchissant sur l'interface liquide-vapeur selon un angle d'incidence aigu par rapport à la normale à l'interface vapeur-liquide, à savoir un angle compris entre 40° et 70°, de préférence entre 50° et 60°. Il est également possible de déduire la position de l'interface liquide-solide 18 à partir de la position de l'interface vapeur-liquide en la multipliant par le coefficient de variation de volume à la solidification du bain de silicium.

L'émetteur d'ultrasons 14 comprend un transducteur 16, par exemple un transducteur LiNbO₃ à température de Curie de 1150°C fonctionnant à 1 MHz, qui est positionné sur un côté latéral extérieur de l'enceinte thermiquement isolante 110 du four de cristallisation et qui est connecté à un dispositif de guidage d'ondes ultrasonores 1 traversant l'épaisseur de la paroi 120 de l'enceinte 110. Le guide d'onde du dispositif de guidage d'onde 1 est par exemple un barreau ayant une section de 10×10 mm² et une longueur de 50 mm et est fixé au transducteur 16 par un adhésif haute température (non représenté) (par exemple l'adhésif Ceramabond^{®} de chez Aremco). Dans cet exemple de réalisation, seule la portion de la surface latérale du barreau située à l'intérieur de l'enceinte de cristallisation (c'est-à-dire dans un environnement haute température quand le four est en fonctionnement) est recouverte par une structure 3 (par exemple en graphite), une couche intermédiaire pulvérulente (par exemple en nitrure de silicium) étant interposée entre le barreau et la structure (voir le détail dans la figure 5).

Après réflexion sur l'interface liquide-vapeur 17, le signal ultrasonore est réceptionné sur une face d'entrée d'un des guides d'ondes d'une matrice de dispositifs de guidage d'ondes située de l'autre côté de l'enceinte (sur la paroi latérale opposée à celle comprenant la source d'ultrasons). Cette matrice est ici constituée de 10×10 barreaux parallélépipédiques de section 1×1 mm² et de longueur 50 mm de silice cristalline dont une partie de la portion de la surface latérale située dans l'enceinte est recouverte d'une structure qui permet de maintenir l'intégrité mécanique des guides d'onde, une couche intermédiaire étant interposée entre la structure et la surface des guides d'onde (non représentées dans la figure 4). Comme pour la source d'ultrasons, les guides d'ondes du détecteur traversent la paroi 120 de l'enceinte, leurs faces de sortie d'onde sont chacune fixées à un transducteur 16 situé à l'extérieur de l'enceinte 110 et au moins une portion de leur surface latérale est recouverte par une structure, avec une couche intermédiaire interposée à l'interface entre les structures et les surfaces des guides d'onde. Par exemple, la structure est en graphite et la couche intermédiaire est en nitrure de silicium.

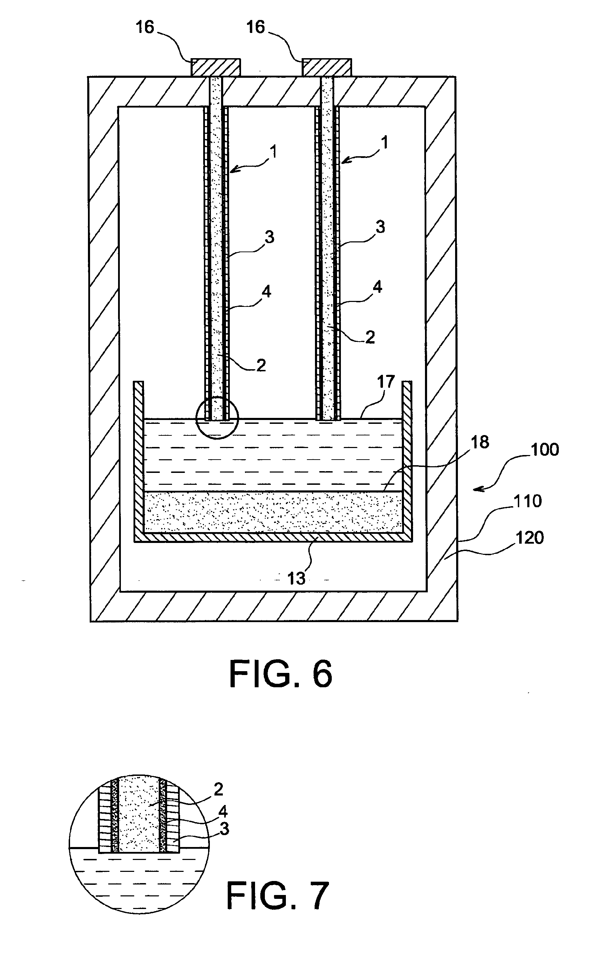

Selon un second exemple de réalisation illustré dans la figure 6, le dispositif de guidage d'onde ultrasonore 1 selon l'invention est utilisé dans un système de brassage du bain de silicium fondu. Le système de brassage comprend au moins un dispositif de guidage d'onde 1 selon l'invention dont une extrémité du guide d'onde est positionnée à la surface du bain de silicium et dont l'autre extrémité du guide d'onde est fixée à un transducteur 16.

Dans notre exemple, on considère un four 100 de solidification dirigée de type Heat Exchanger ou Bridgman-Stockbarger à chauffage résistif adapté à la croissance du silicium pour des applications photovoltaïques et travaillant sous balayage d'argon.

Les dimensions du creuset 13 sont de 20×20 cm² pour la base et 20 cm pour la hauteur.

Le système de brassage du bain de silicium par ultrasons est ici constitué de quatre barreaux 2 de silice cristalline (dont deux barreaux sont représentés dans la figure 5) qui sont positionnés sur les arrêtes parallèles d'un parallélépipède de base 10×10 cm² positionné pour que les quatre barreaux affleurent la surface du bain de silicium (voir la figure 6 et la figure 7). Lorsqu'on dit que les barreaux affleurent la surface, les barreaux sont en fait en contact avec la surface du bain, mais la surface de contact des barreaux avec la surface du bain de liquide fondu est maintenue à son minimum afin de limiter les interactions chimiques avec le silicium.

Les quatre barreaux ont une base de 2×2 cm² et une hauteur de 30 cm pour permettre de déporter les transducteurs ultrasonores 16, situés à l'extrémité supérieure des barreaux, en dehors de l'enceinte de solidification. Dans cet exemple de réalisation, à chaque barreau 2 de silice cristalline est connecté un transducteur LiNbO₃, fonctionnant à une fréquence de 1 MHz, via un adhésif haute température (par exemple un adhésif Aremco Ceramabond^{®}). La surface des barreaux présente à l'intérieur de l'enceinte est recouverte d'une couche pulvérulente 3 de carbure de silicium et sont totalement recouverts par une structure de protection 4 en graphite. La structure de protection peut par exemple être un fourreau ou une gaine.

### BIBLIOGRAPHIE

[1] P. Dold, M. Heidler, A. Drevennann, G. Zimmermann, "In situ observation of growth interfaces by ultrasound", Journal of Crystal Growth, 256, (2003), 352-360.
[2] S. Eckert, G. Gerbeth, V.I. Melnikov, "Velocity measurements at high temperatures by ultrasound Doppler velocimetry using an acoustic wave guide", Experiments in Fluids, 35, (2003), 381-388.
[3] G.N. Kozhemyakin, L.V. Zolkina, M.A. Rom, "Influence of ultrasound on die growth striations and electrophysical properties of GaxIn1-xSb single crystals", Solid-State Electronics, 51, (2007), 820-822.
[4] N. Yoshimoto, M. Ikeda, M. Yoshizawa, S. Kimura, "Sound velocity of molten silicon", Physica B 219&220, (1996), 623-625.
[5] JP 2007 110371 A, Kaijo KK, 26 avril 2007.

## Revendications

1. Dispositif de guidage d'ondes ultrasonores (1) apte à être utilisé dans une enceinte (110) thermiquement isolante d'un four de cristallisation (100) du silicium et destiné à être inséré partiellement dans l'enceinte (110) dudit four par un orifice ménagé dans la paroi (120) de l'enceinte, **caractérisé en ce qu'**il comprend :
- un guide d'onde (2) en silice cristalline, comprenant une face d'entrée d'une onde ultrasonore, une face de sortie d'une onde ultrasonore et une surface latérale reliant la face d'entrée et la face de sortie,
- une structure (3) en graphite ou en carbure de silicium, qui entoure au moins partiellement la surface latérale du guide d'onde,
- une couche intermédiaire pulvérulente (4) en nitrure de silicium ou en carbure de silicium, qui recouvre au moins les portions de la surface latérale du guide d'onde qui sont entourées par la structure (3).

2. Dispositif de guidage d'ondes ultrasonores selon la revendication 1, dans lequel la structure recouvre de 40 à 100% de la surface latérale du guide d'onde, préférentiellement de 60 à 80%.

3. Système de contrôle de l'état d'avancement de la cristallisation d'un bain de silicium fondu réalisée dans une enceinte (110) thermiquement isolante d'un four de cristallisation (100), comprenant une source d'ultrasons (14) et un détecteur d'ultrasons (15), **caractérisé en ce que** :
- la source d'ultrasons (14) comprend n ensemble(s), n étant un nombre entier supérieur ou égal à 1, chaque ensemble de la source comprenant un transducteur (16), apte à émettre une onde ultrasonore, relié à un dispositif de guidage d'onde (1) selon l'une quelconque des revendications 1 à 2, apte à guider l'onde ultrasonore, produite par ledit transducteur, vers l'interface vapeur-liquide (17) du bain de silicium liquide ;
- le détecteur d'ultrasons (15) comprend au moins 2n ensembles, chaque ensemble du détecteur comprenant un dispositif de guidage d'onde (1) selon l'une quelconque des revendications 1 à 2 relié à un transducteur (16) apte à détecter une onde ultrasonore, ledit dispositif de guidage d'onde étant apte à guider une onde ultrasonore vers ledit transducteur ;
les n ensembles de la source et les au moins 2n ensembles du détecteur étant placés au dessus de l'interface vapeur-liquide (17) en des positions distinctes telles que l'onde ultrasonore produite par l'un des transducteurs de la source (14) soit incidente sur l'interface vapeur-liquide selon un angle aigu par rapport à la normale à ladite interface et que ladite onde ultrasonore, réfléchie par l'interface vapeur-liquide (17) selon ce même angle aigu, soit détectée par l'un des transducteurs (16) du détecteur (15),
le transducteur de la source et du détecteur étant situés à l'extérieur de l'enceinte et les dispositifs de guidage d'onde de la source et du détecteur traversant la paroi de ladite enceinte.

4. Système de brassage d'un bain de silicium fondu dans une enceinte (110) thermiquement isolante d'un four de cristallisation (100), comprenant au moins un moyen de brassage destiné à être mis en contact avec la surface du bain de silicium fondu, **caractérisé en ce que** ledit moyen de brassage comprend un dispositif de guidage d'ondes ultrasonores (1) selon l'une quelconque des revendications 1 à 2.

## Patentansprüche

1. Einrichtung (1) zur Führung von Ultraschallwellen, welche zur Verwendung in einem Gehäuse (110) geeignet ist, welches von einem Silizium-Kristallisationsofen (100) wärmeisoliert ist, und welche dazu bestimmt ist, teilweise in das Gehäuse (110) des Ofens durch eine Öffnung in der Wand (120) des Gehäuses eingeführt zu werden, **dadurch gekennzeichnet, dass** die Einrichtung Folgendes aufweist:
- einen Wellenleiter (2) aus kristallinem Siliziumdioxid, welcher eine Eintrittsfläche für eine Ultraschallwelle, eine Austrittsfläche für eine Ultraschallwelle sowie eine seitliche Oberfläche aufweist, welche die Eintrittsfläche und die Austrittsfläche miteinander verbindet;
ein Gefüge (3) aus Graphit oder Siliziumkarbid, welches die seitliche Oberfläche des Wellenleiters zumindest teilweise umgibt;
- eine pulverförmige Zwischenschicht (4) aus Siliziumnitrid oder aus Siliziumkarbid, welche zumindest die Abschnitte der seitlichen Oberfläche des Wellenleiters bedeckt, welche von dem Gefüge (3) umgeben sind.

2. Einrichtung zur Führung von Ultraschallwellen nach Anspruch 1, in welcher das Gefüge 40 bis 100%, bevorzugt 60 bis 80%, der seitlichen Oberfläche des Wellenleiters bedeckt.

3. System zur Steuerung des Fortschrittstandes der Kristallisation eines Silizium-Schmelzbads, welches in einem Gehäuse (110) realisiert ist, das von einem Kristallisationsofen (100) wärmeisoliert ist, wobei das System eine Ultraschallquelle (14) und einen Ultraschalldetektor (15) aufweist, **dadurch gekennzeichnet, dass**:
- die Ultraschallquelle (14) die Anzahl n an Einheiten aufweist, wobei n eine ganze Zahl größer oder gleich 1 ist, wobei jede Einheit der Quelle einen Messwandler (16) aufweist, welcher zum Emittieren einer Ultraschallwelle geeignet ist und welcher mit einer Wellen-Führungseinrichtung (1) nach einem der Ansprüche 1 bis 2 verbunden ist, welche zur Führung der von dem Messwandler erzeugten Ultraschallwelle durch die Dampf/Flüssigkeits-Grenzfläche (17) des flüssigen Siliziumbads fähig ist;
- der Ultraschalldetektor (15) mindestens 2n Einheiten aufweist, wobei jede Einheit des Detektors eine Wellen-Fürhungseinrichtung (1) nach einem der Ansprüche 1 bis 2 umfasst, welche mit einem Messwandler (16) verbunden ist, welcher zur Detektion einer Ultraschallwelle geeignet ist, wobei die Wellen-Führungseinrichtung geeignet ist, eine Ultraschallwelle durch den Messwandler zu führen;
wobei die n Einheiten der Quelle und die mindestens 2n Einheiten des Detektors oberhalb der Dampf-Flüssigkeits-Grenzfläche (17) an verschiedenen Positionen angeordnet sind, so dass die von einem der Messwandler der Quelle (14) erzeugte Ultraschallwelle auf die Dampf-Flüssigkeits-Grenzfläche gemäß einem spitzen Winkel in Bezug auf eine Normale zu dieser Grenzfläche einfällt und dass die Ultraschallwelle, welche von der Dampf-Flüssigkeits-Grenzfläche (17) gemäß dem gleichen spitzen Winkel reflektiert wird, von einem der Messwandler (16) des Detektors (15) erfasst bzw. detektiert wird,
wobei der Messwandler der Quelle und des Detektors außerhalb des Gehäuses angeordnet ist und die Wellen-Führungseinrichtungen der Quelle und des Detektors die Innenwand des Gehäuses durchqueren.

4. System zur Mischung eines Silizium-Schmelzbads in einem Gehäuse (110), welches von einem Kristallisationsofen (100) wärmeisoliert ist, wobei das System mindestens eine Mischeinrichtung umfasst, welche dazu bestimmt ist, mit der Oberfläche des Silizium-Schmelzbads in Kontakt gebracht zu werden, **dadurch gekennzeichnet, dass** die Mischeinrichtung eine Führungseinrichtung (1) für Ultraschallwellen nach einem der Ansprüche 1 bis 2 aufweist.

## Claims

1. Ultrasonic waveguide device (1) suitable for being used in a heat-insulating enclosure (110) of a silicon crystallisation furnace (100) and intended to be partially inserted into the enclosure (110) of said furnace via an orifice provided in the wall (120) of the enclosure, **characterised in that** it comprises:
- a crystalline silica waveguide (2), comprising an ultrasonic wave input face, an ultrasonic wave output face and a lateral surface joining the input face and the output face,
- a graphite or silicon carbide structure (3), encompassing at least partially the lateral surface of the waveguide,
- a silicon nitride or silicon carbide powder intermediate layer (4), covering at least the portions of the lateral surface of the waveguide encompassed by the structure (3).

2. Ultrasonic waveguide device according to claim 1, wherein the structure covers 40 to 100% of the lateral surface of the waveguide, preferentially 60 to 80%.

3. System for monitoring the progress of the crystallisation of a molten silicon bath produced in a heat-insulating enclosure (110) of a crystallisation furnace (100), comprising an ultrasound source (14) and an ultrasound detector (15), **characterised in that**:
- the ultrasound source (14) comprises n assembly/assemblies, n being an integer greater than or equal to 1, each assembly of the source comprising a transducer (16), suitable for transmitting an ultrasonic wave, connected to a waveguide device (1) according to any of claims 1 to 2, suitable for guiding the ultrasonic wave, produced by said transducer, towards the vapour-liquid interface (17) of the liquid silicon bath;
- the ultrasound detector (15) comprises at least 2n assemblies, each assembly of the detector comprising a waveguide device (1) according to any of claims 1 to 2 connected to a transducer (16) suitable for detecting an ultrasonic wave, said waveguide device being suitable for guiding an ultrasonic wave towards said transducer;
the n assemblies of the source and the at least 2n assemblies of the detector being positioned above the vapour-liquid interface (17) at separate positions such that the ultrasonic wave produced by one of the transducers of the source (14) is incident on the vapour-liquid interface according to an acute angle in relation to the normal at said interface and that said ultrasonic wave, reflected by the vapour-liquid interface (17) according to said acute angle, is detected by one of the transducers (16) of the detector (15),
the transducer of the source and the detector being situated outside the enclosure and the waveguide devices of the source and the detector passing through said enclosure.

4. System for mixing a molten silicon bath in a heat-insulating enclosure (110) of a crystallisation furnace (100), comprising at least one mixing means intended to be placed in contact with the surface of the molten silicon bath, **characterised in that** said mixing means comprises an ultrasonic waveguide device (1) according to any of claims 1 to 2.
